(19) Europäisches Patentamt
European Patent Office
Office européen des brevets

(11) **EP 3 736 580 B1**

(12) **EUROPÄISCHE PATENTSCHRIFT**

(45) Veröffentlichungstag und Bekanntmachung des Hinweises auf die Patenterteilung:
**02.08.2023   Patentblatt 2023/31**

(21) Anmeldenummer: **19173222.1**

(22) Anmeldetag: **08.05.2019**

(51) Internationale Patentklassifikation (IPC):
**G01R 23/16** (2006.01)       **G01R 19/00** (2006.01)

(52) Gemeinsame Patentklassifikation (CPC):
**G01R 23/16; G01R 19/0015**

(54) **ERKENNEN EINES GLEICHSTROMANTEILS IN EINER INDUKTIVEN EINRICHTUNG**

DETECTION OF A DC COMPONENT IN AN INDUCTIVE DEVICE

DÉTECTION D'UNE COMPOSANTE DE COURANT CONTINU DANS UN DISPOSITIF INDUCTIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**11.11.2020   Patentblatt 2020/46**

(73) Patentinhaber: **Siemens Energy Global GmbH & Co. KG**
**81739 München (DE)**

(72) Erfinder:
• **Scala, Mario**
  **8010 Graz (AT)**
• **Klammler, Franz**
  **8163 Fladnitz (AT)**

(56) Entgegenhaltungen:
EP-A1- 2 905 627       EP-A1- 3 133 632
CN-A- 109 459 613

**Beschreibung**

GEBIET DER ERFINDUNG

Die Erfindung betrifft ein Verfahren zum Erkennen eines Gleichstromanteils in einer induktiven Einrichtung, z.B. in einem Transformator oder einer Drossel, gemäß Anspruch 1.

STAND DER TECHNIK

Ein solches Verfahren ist aus der EP 2 905 627 A1 bekannt. Dort ist ein Verfahren zum Erkennen eines Gleichstromanteils in einer induktiven Einrichtung beschrieben. Zunächst wird eine Schwingungsspektrum der induktiven Einrichtung aufgezeichnet und die geraden und ungeraden Harmonischen identifiziert. Schließlich werden die Schwingungswerte der geraden und ungeraden Harmonischen miteinander verglichen, um auf einen Gleichstromanteil schließen zu können.

Gleichströme sind in einem Wechselspannungs-Energieversorgungsnetz störend, da sie zu erhöhten Verlusten und in induktiven Einrichtungen zu unangenehmen Geräuschen führen können, weil der Gleichstrom zu einer Magnetisierung des Kerns der induktiven Einrichtung führt, was durch die Verwendung von magnetisch hochpermeablen Kernen verstärkt wird. Es gibt verschiedene Ursachen für Gleichströme im Wechselspannungs-Energieversorgungsnetz: diese können aus erneuerbaren Energiequellen bzw. deren Stromrichtern stammen, oder sie können durch geomagnetische Einflüsse, wie den Sonnenwind, hervorgerufen werden, wobei hier die Ursache nicht örtlich lokalisiert werden kann. Die Geräusche können auch durch die induktive Einrichtung selbst hervorgerufen werden: durch Remanenzeffekte des Kerns des Transformators bzw. der Drossel, durch den sogenannten Inrush-current oder andere Schalthandlungen, oder durch mechanisch unzulänglich verbundene Bauteile der induktiven Einrichtung, wie Pumpen, Lüfter oder andere Zusatzaggregate, die bewegliche Teile enthalten.

Der Nachweis von Gleichströmen in einer induktiven Einrichtung erfolgt durch direkte oder indirekte elektrische Messung an der induktiven Einrichtung, etwa unter Ausnützung des Faraday-Effekts oder mit Hilfe von Lichtleitern, z.B. am Sternpunkt eines Transformators, sofern zugänglich. Diese elektrischen Messungen sind apparativ aufwändig in dem Sinn, dass solche Messgeräte bereits in der induktiven Einrichtung vorhanden sein müssen und nur sehr aufwändig nachgerüstet werden können. Für die Auswertung von akustischen Messreihen, aufgenommen an der induktiven Einrichtung zur Beurteilung eines etwaigen Gleichstromanteils, benötigt es einen Experten.

DARSTELLUNG DER ERFINDUNG

Es ist somit eine Aufgabe der Erfindung, ein Verfahren zum Erkennen eines Gleichstromanteils in einer induktiven Einrichtung zur Verfügung zu stellen, die die oben genannten Nachteile vermeidet. Insbesondere soll das Verfahren ohne Messgeräte im Inneren einer induktiven Einrichtung und ohne Beiziehung eines Experten auskommen.

Diese Aufgabe wird durch ein Verfahren nach Anspruch 1 gelöst.

Die unangenehmen Geräusche entstehen durch unsymmetrische Schwingungen. Als unsymmetrische Schwingungen werden ungerade harmonische Schwingungen oberhalb der Grundschwingung verstanden. Die Grundschwingung, mit der Grundfrequenz, wird als 1. harmonische Schwingung, kurz 1. Harmonische, bezeichnet. Die 2. harmonische Schwingung, kurz 2. Harmonische, hat die doppelte Frequenz der Grundschwingung, die 3. harmonische Schwingung, kurz 3. Harmonische, hat die dreifache Frequenz der Grundschwingung, u.s.w. Die 2., 4., 6., 8., u.s.w. Harmonische werden als gerade Harmonische, als symmetrische Schwingungen bzw. als Schwingungen mit gerader Frequenz bezeichnet. Die 3., 5., 7., 9., u.s.w. Harmonische werden als ungerade Harmonische, als unsymmetrische Schwingungen bzw. als Schwingungen mit ungerader Frequenz bezeichnet.

Dadurch, dass eine oder mehrere unsymmetrische Schwingungen detektiert werden, welche für die störenden Geräusche ursächlich sind, kann ein Rückschluss auf das Vorliegen eines Gleichstromanteils in der induktiven Einrichtung gezogen werden. Durch den Vergleich mit einer oder mehreren symmetrischen Schwingungen kann ausgeschlossen werden, dass es sich um einen "normalen", also relativ niedrigen, Anteil von unsymmetrischen Schwingungen handelt, der auch ohne störende Geräusche vorliegen kann.

Der Computer wird dabei jedenfalls für die Bestimmung des Frequenzspektrums verwendet, für das Bestimmen des Schwingungswerts zumindest einer ungeraden Harmonischen im Frequenzspektrum sowie für das Vergleichen des Schwingungswerts der ungeraden Harmonischen mit dem Schwingungswert der zumindest einen geraden Harmonischen im Frequenzspektrum. In der Regel wird der Computer auch den Unterschied des Schwingungswerts der ungeraden Harmonischen vom Schwingungswert der geraden Harmonischen bewerten, etwa anhand von vorgegebenen Grenzwerten. Wenn einem Benutzer der Schwingungswert der ungeraden und der geraden Harmonischen angezeigt wird, könnte der Benutzer - gegebenenfalls anhand von weiteren angezeigten Informationen - auch selbst beurteilen, ob der Unterschied ausreichend für das Vorliegen eines Gleichstromanteils ist.

Hauptsächlich ist das Verfahren aber als vollautomatisches Verfahren gedacht, bei dem das Schwingungssignal aufgezeichnet wird und anschließend durch einen Computer mit einem entsprechenden Auswerteprogramm das Frequenzspektrum berechnet wird, anschließend daraus der Schwingungswert zumindest einer ungeraden und zumindest einer geraden Harmonischen bestimmt wird, die Differenz zwischen den Schwingungswerten der geraden und ungeraden Harmonischen berechnet wird (wobei bei mehreren geraden und/oder ungeraden Frequenzen vorher ein gemittelter Schwingungswert der Harmonischen berechnet wird) und schließlich die ermittelte Differenz mit einem vorgegebenen Differenzwert verglichen wird: liegt die ermittelte Differenz über dem vorgegebenen Differenzwert, liegt ein Gleichstromanteil vor.

Bei einer bevorzugten Ausführungsform des erfindungsgemäßen Verfahrens ist vorgesehen, dass für das Feststellen eines Gleichstromanteils eine Wahrscheinlichkeit für das Vorliegen eines Gleichstromanteils angegeben wird, wobei die Wahrscheinlichkeit umso größer ist, je größer der Unterschied zwischen dem Schwingungswert der mindestens einen ungeraden Harmonischen und dem Schwingungswert der mindestens einen geraden Harmonischen ist.

Dabei kann z.B. vorgesehen werden, dass für verschiedene Wahrscheinlichkeiten für das Vorliegen eines Gleichstromanteils entsprechend verschiedene Unterschiede vorgegeben werden, also verschiedene Unterschiede zwischen dem Schwingungswert der mindestens einen ungeraden Harmonischen und dem Schwingungswert der mindestens einen geraden Harmonischen. Bei einer bevorzugten Ausführungsform des erfindungsgemäßen Verfahrens ist vorgesehen, dass der Schwingungswert einer oder mehrerer geraden Frequenzen mit einem Schwingungswert des Rauschens des Schwingungssignals verglichen wird und bei einem, gegenüber einer vorgegebenen Differenz zwischen den Schwingungswerten, geringeren Unterschied das Vorliegen eines Gleichstromanteils mit einem Unsicherheitsfaktor versehen wird. Auf diese Weise wird die Brauchbarkeit der geraden Oberschwingungen bei der Bewertung des Vorliegens eines Gleichstromanteils überprüft. Wenn der Schwingungswert der Intensität der geraden Harmonischen nur wenig von jenem der Intensität des Rauschens des Gesamtsignals abweicht, dann macht der Rauschanteil der Mess-Signale die Auswertung unsicher.

Erfindungsgemäß ist vorgesehen, dass die beiden größten Schwingungswerte der geraden Frequenzen zueinander ins Verhältnis gesetzt werden und bei einem Verhältnis größer einem vorgegebenen Verhältnis das Vorliegen eines Gleichstromanteils mit einem Unsicherheitsfaktor versehen wird. Denn wenn der Unterschied zwischen diesen beiden geraden Frequenzen sehr groß ist, dann ist es wahrscheinlich, dass eine Störung oder Resonanz der geraden Frequenzen vorliegt. Dies wiederum kann die Auswertung verfälschen, ob ein Gleichstromanteil vorliegt. Bei einer bevorzugten Ausführungsform des erfindungsgemäßen Verfahrens ist vorgesehen, dass die beiden größten Schwingungswerte der ungeraden Frequenzen, die ungleich der Grundfrequenz sind, zueinander ins Verhältnis gesetzt werden und bei einem Verhältnis größer einem vorgegebenen Verhältnis das Vorliegen eines Gleichstromanteils mit einem Unsicherheitsfaktor versehen wird. In diesem Fall geht man von einem dominanten Auftreten einer Frequenz ungleich der Grundfrequenz aus, was auf eine Störung oder Resonanz der ungeraden Frequenzen hindeutet. Dies wiederum kann ebenfalls die Auswertung verfälschen, ob ein Gleichstromanteil vorliegt.

Bei einer bevorzugten Ausführungsform des erfindungsgemäßen Verfahrens ist vorgesehen, dass der Schwingungswert der Grundschwingung mit dem Schwingungswert der restlichen gemessenen Frequenzen ins Verhältnis gesetzt wird und bei einem Verhältnis größer einem vorgegebenen Verhältnis das Vorliegen eines Gleichstromanteils mit einem Unsicherheitsfaktor versehen wird. Liegt nämlich eine Dominanz der Grundschwingung vor, so ist es wahrscheinlich, dass das Störgeräusch ein Stromgeräusch ist. Dies kann bestätigt werden, wenn sich der Schwingungswert der Grundschwingung bei höherem Laststrom ebenfalls erhöht.

Bei einer bevorzugten Ausführungsform des erfindungsgemäßen Verfahrens ist vorgesehen, dass das Vorliegen eines Gleichstromanteils mit einer niedrigeren Wahrscheinlichkeit bewertet wird, wenn sich der Schwingungswert der ungeraden Harmonischen vom Schwingungswert der geraden Harmonischen um ein vorgegebenes Ausmaß unterscheidet und dieser Unterschied mit zunehmendem Laststrom zunimmt. Wenn also ungerade Oberschwingung mit zunehmendem Laststrom auftreten, dann ist es wahrscheinlicher, dass diese auf lose Teile innerhalb oder außerhalb der induktiven Einrichtung, z.B. innerhalb oder außerhalb des Transformatorkessels, zurückzuführen sind.

Es kann vorgesehen sein, dass das erfindungsgemäße Verfahren mit einer unterschiedlichen Anzahl an geraden und/oder ungeraden Frequenzen wiederholt wird und eine Abweichung beim Feststellen eines Gleichstromanteils als Maß für die Robustheit des Ergebnisses herangezogen wird.

Da das erfindungsgemäße Verfahren in der Regel durch einen Computer ausgeführt wird, umfasst die gegenständliche Erfindung auch ein Computerprogrammprodukt, welches ein Programm umfasst, das direkt in einen Prozessor eines Computers ladbar ist, mit Programm-Mitteln, um alle Schritte des erfindungsgemäßen Verfahrens auszuführen, wenn das Programm vom Prozessor ausgeführt wird. Das Computerprogrammprodukt kann beispielsweise ein Datenträger sein, auf welchem ein entsprechendes Computerprogramm gespeichert ist, oder es kann ein Signal oder Datenstrom sein, der über eine Datenverbindung in den Prozessor geladen werden kann.

Das Computerprogramm kann also veranlassen, dass mittels entsprechender Messgeräte, die im Computer vorgesehen oder mit diesem verbunden sind, das Aufzeichnen eines Schwingungssignals, entweder des von der Einrichtung abgestrahlten Schalls oder der mechanischen Schwingung der Einrichtung erfolgt. Der Computer bestimmt dann das Frequenzspektrum des Schwingungssignals und den Schwingungswert zumindest einer ungeraden Harmonischen im Frequenzspektrum. Anschließend erfolgt das Vergleichen des Schwingungswerts der ungeraden Harmonischen mit dem Schwingungswert zumindest einer geraden Harmonischen im Frequenzspektrum, wobei dann vom Computer ein Gleichstromanteil festgestellt wird, wenn sich der Schwingungswert der ungeraden Harmonischen vom Schwingungswert der geraden Harmonischen um ein vorgegebenes Ausmaß unterscheidet. Entsprechend kann der Computer die Verfahrensschritte der abhängigen Ansprüche ausführen.

Der Computer kann insbesondere ein tragbarer Computer oder ein Smartphone sein.

Mit der vorliegenden Erfindung ist es möglich, eine Auswertung zum Vorliegen eines Gleichstromanteils durchzuführen, ohne über eine Information des Betriebszustandes und der Anspeisung (Strom und Spannung) der induktiven Einrichtung zu verfügen und ohne einer daraus abgeleiteter Modellierung der Spektren, also ohne Soll-Ist Vergleich.

WEGE ZUR AUSFÜHRUNG DER ERFINDUNG

Die Erfindung wird nun anhand von Ausführungsbeispielen näher erläutert. Diese sind beispielhaft und sollen den Erfindungsgedanken zwar darlegen, ihn aber keinesfalls einengen oder gar abschließend wiedergeben. Ausgangslage für das erfindungsgemäße Verfahren ist eine vorhandene sogenannte Schmalband-Analyse (englisch "narrow band analysis") eines Schwingungs- oder Geräuschsignals eines Transformators oder einer Drossel. Dabei werden folgende Größen verwendet:

| Größe | Bezeichnung | Erklärung |
|---|---|---|
| $S_{xN}$ | Signalwert | Größe der Einzelkomponente bzw. des Signals, linear dargestellt (kein dB-Wert); x steht für g (gerade), u (ungerade), oder n (Rauschen, noise) |
| gN | gerade | Art der spektralen Signal-Komponente |
| uN | ungerade | |
| nN | "noise" (Rauschen) | |
| N | "Ordnungszahl" | Ordnungszahl des Signals: $$N = 1, 2, 3, \ldots N_{max} \approx 6 \,(\max. 10)_{N=1:}$$ Grundschwingung, darüber: harmonische Oberschwingung |
| $f_{gN}$ | gerade Frequenz | $$f_{gN} = 50^1 \cdot 2 \cdot N$$ im Fall von 50 Hz Netzspannungsfrequenz |
| f uN | ungerade Frequenz | $$f_{uN} = 50^1 \cdot 2 \cdot \left(N + \frac{1}{2}\right)$$ im Fall von 50 Hz Netzspannungsfrequenz |
| f ngN | Rauschfrequenz "noise" | $$f_{nN-} = 50^1 \cdot 2 \cdot \left(N - \frac{1}{4}\right) \text{ und}$$ $$f_{nN+} = 50^1 \cdot 2 \cdot \left(N + \frac{1}{4}\right)$$ $$S_{nN} = \left(S_{fnN-} + S_{fN+}\right)/2$$ im Fall von 50 Hz Netzspannungsfrequenz |
| $A_{lin}$ | linearer Faktor der A-Bewertung | f-abhängige A-Bewertung aus Akustik, de-logarithmiert |
| $S_{xNA}$ | S, A-bewertet | $$S_{xNA} = S_{xN} \cdot A\left(f_{xN}\right)$$ |

(fortgesetzt)

| Größe | Bezeichnung | Erklärung |
|---|---|---|
| $S_{xTotA}$ | S-total, A-bewertet | Summiertes Signal der Einzelkomponenten $S_{xN}$ $$S_{xTotA} = \sum_{N=1}^{N_{max}} S_{xN} \cdot A(f_{xN})$$ |
| $S_{gTot-1,A}$ | S-total ohne Grundschwingung, A-bewertet | Summiertes Signal der Einzelkomponenten $S_{xN}$ $$S_{gTot-1,A} = \sum_{N=2}^{N_{max}} S_{xN} \cdot A(f_{xN})$$ |
| | | $l_g \equiv \log_{10}$ |
| | | $R \equiv$ Ratio (Verhältnis) |
| | | $S_{xN} \equiv S_{fxN}$ |

Die Hochziffer 1 weist darauf hin, dass der Schwingungswert 50 für eine Netzspannungsfrequenz von 50 Hz zu verwenden ist. Bei einer anderen Netzspannungsfrequenz, z.B. bei 60 Hz Netzspannungsfrequenz, ist dann die entsprechende Frequenz einzusetzen, z.B. 60 anstelle 50. Der genaue Schwingungswert der Netzspannungsfrequenz ist aus der Frequenz der einzelnen $S_{gN}$-Werte bis zu $N_{max}$ sicherzustellen.

Typisch für einen Transformator (oder eine Drossel) sind die unten angeführten geraden Frequenzanteile $S_{gN}$ einer Schwingung bzw. eines Geräusches. Sie sollen sich deutlich gegen das Rauschen abheben, das im Folgenden über die Signalanteile mit der Rauschfrequenz $S_{nN}$ beschrieben ist. Ein Verfahrensteil bei diesem Ausführungsbeispiel besteht in der Erkennung bzw. Ausfilterung nicht verwertbarer Messergebnisse.

Als Zeitdauer für eine Messung Schwingungs- oder Geräuschsignals werden mehr als 30 Sekunden empfohlen. Falls Verdacht auf Störgeräusche bestehen, die nicht auf einem Gleichstromanteil basieren, wäre eine längere Messdauer empfehlenswert, etwa mehr als eine Minute.

Zuerst werden die Kriterien für die Brauchbarkeit der Mess-Signale angewendet.

Hier kann als erstes Kriterium die Brauchbarkeit der geraden Mess-Signale ermittelt werden, indem das Signal/Rauschverhältnis in dB bestimmt wird, und zwar zuerst für mehrere Einzelsignale mit gerader Frequenz:

$$R_{Noise,gN}\,[dB] = 10 \cdot \lg\left(\frac{S_{gN}}{S_{nN}}\right)$$

Anschließend wird daraus das gesamte Signal/Rauschverhältnis der betrachteten geraden Frequenzen bestimmt:

$$R_{Noise,g} = \frac{1}{N_{max}} \cdot \sum_{N=1}^{N_{max}} R_{NoiseN}$$

Wenn dieses gesamte Signal/Rauschverhältnis kleiner als ein vorgegebener Schwingungswert Limit_$R_{Noise,g}$ in dB (z.B: 6 dB) ist, dann macht der Rauschanteil der Mess-Signale die Auswertung unsicher und dann wird das Vorliegen eines Gleichstromanteils mit einem Unsicherheitsfaktor bzw. einer niedrigeren Wahrscheinlichkeit versehen.

Als zweites Kriterium für die Brauchbarkeit der Mess-Signale können herausragende Einzelwerte der geraden und/oder ungeraden Frequenzen ermittelt werden.

Dazu werden erstens die beiden größten $S_{gN}$-Werte: $S_{gmax1,A}$ und $S_{gmax2,A}$ ausgewählt und es wird überprüft, ob deren Verhältnis

$$R_{g\,max}\,\left[dB(A)\right] = 10 \cdot \lg\left(\frac{S_{g\,max1,A}}{S_{g\,max2,A}}\right)$$

größer als ein vorgegebener Schwingungswert Limit_$R_{Sg}$ (z.B. 10 dB(A)) ist. In diesem Fall liegt der Verdacht einer Störung oder Resonanz der geraden Frequenzen vor. Das Vorliegen eines Gleichstromanteils wird dann mit einem Unsicherheitsfaktor bzw. einer niedrigeren Wahrscheinlichkeit versehen.

Zweitens wird das gleiche Verfahren für die beiden größten Schwingungswerte der ungeraden Frequenzen durchgeführt. Es werden die beiden größten $S_{uN}$-Werte: $S_{umax1,A}$ und $S_{umax2,A}$ ausgewählt und es wird überprüft, ob deren Verhältnis

$$R_{u\,max}\,\left[dB(A)\right] = 10 \cdot \lg\left(\frac{S_{u\,max1,A}}{S_{u\,max2,A}}\right)$$

größer als ein vorgegebener Schwingungswert Limit_$R_{Su}$ (z.B. 10 dB(A)) ist. In diesem Fall liegt der Verdacht einer Störung oder Resonanz der ungeraden Frequenzen vor. Das Vorliegen eines Gleichstromanteils wird dann mit einem Unsicherheitsfaktor bzw. einer niedrigeren Wahrscheinlichkeit versehen.

Als drittes Kriterium wird untersucht, ob die Grundschwingung übermäßig dominiert, weil dies ein Hinweis darauf ist, dass das Stromgeräusch nicht von einem Gleichstromanteil stammt, sondern von der Grundschwingung dominiert wird. Dazu wird das folgende Verhältnis berechnet:

$$R_{Grund}\,\left[dB(A)\right] = 10 \cdot \lg\left(\frac{S_{g1,A}}{S_{gTot-1,A}}\right)$$

Wenn dieses Verhältnis größer als ein vorgegebener Schwingungswert Limit_$R_{Grund}$ (z. B 0 dB(A)) ist, dann wird das Vorliegen eines Gleichstromanteils mit einem Unsicherheitsfaktor bzw. einer niedrigeren Wahrscheinlichkeit versehen.

Als viertes Kriterium, welches das Hauptkriterium für die Bestimung des Gleichstromanteils darstellt, wird dann der ungerade Anteil der Frequenzen bestimmt. Dazu wird das folgende Verhältnis gebildet:

$$R_{uns}\,\left[dB(A)\right] = 10 \cdot \lg\left(S_{uTot,A}\big/S_{gTot,A}\right)$$

Liegt dieses Verhältnis unter einem ersten vorgegebenen Schwingungswert Limit_$R1_{uns}$, z.B. -9 dB(A), dann liegt sicher kein ungerader Anteil vor und damit wird festgestellt, dass kein Gleichstromanteil vorliegt.

Liegt dieses Verhältnis über dem ersten vorgegebenen Schwingungswert Limit_$R1_{uns}$, z.B. -9 dB(A), aber unter einem zweiten vorgegebenen Schwingungswert Limit_$R2_{uns}$, z.B. -4 dB(A), dann liegt ein kleiner ungerader Anteil an Frequenzen vor, und es besteht ein Verdacht auf das Vorliegen eines Gleichstromanteils mit einer bestimmten Wahrscheinlichkeit.

Liegt dieses Verhältnis $R_{uns}$ bei oder über dem zweiten vorgegebenen Limit_$R2_{uns}$, so liegt ein hoher ungerader Anteil an Frequenzen und damit ein deutlicher DC-Verdacht vor. Die Wahrscheinlichkeit für das Vorliegen eines Gleichstromanteils ist dann größer als für den Fall, wo das Verhältnis $R_{uns}$ nur zwischen erstem vorgegebenen Schwingungswert Limit_$R1_{uns}$ und zweitem vorgegebenen Schwingungswert Limit_$R2_{uns}$ liegt.

Die Wahrscheinlichkeit für das Vorliegen eines Gleichstromanteils, die mit dem vierten Kriterium bestimmt wird, kann durch die in den ersten bis dritten Kriterien bestimmten Unsicherheiten bzw. Wahrscheinlichkeiten entsprechend zu vermindern sein.

Schließlich kann die Auswertung, ob ein Gleichstromanteil vorliegt, noch durch die Bestimmung und Angabe der spektralen Qualität bewertet werden. Dazu wird die Auswertung mit einem anderen spektralen Umfang wiederholt. Dazu wird die Anzahl N der betrachteten Frequenzen variiert, z.B. eine Frequenz weniger, $N_{max}-1$, oder drei Frequenzen

mehr, $N_{max}$ +3, verwendet. Wurden also bei der ersten Bewertung, ob ein Gleichstromanteil vorliegt, 7 Frequenzen herangezogen, wird die gleiche Bewertung nochmals mit 6 und/oder 10 Frequenzen wiederholt.

Wenn das Ergebnis, also die Wahrscheinlichkeit für das Vorliegen eines Gleichstromanteils, dann immer noch im Wesentlichen gleich bleibt, liegt ein spektral robustes Ergebnis vor. Andernfalls kann eine Bewertung bzw. Ausgabe an den Anwender erfolgen, dass das Ergebnis spektral nicht stabil bzw. spektral sensibel ist.

**Patentansprüche**

1. Verfahren zum Erkennen eines Gleichstromanteils in einer induktiven Einrichtung, z.B. in einem Transformator oder einer Drossel, umfassend folgende Verfahrensschritte unter Verwendung eines Computers:

   - Aufzeichnen eines Schwingungssignals, entweder des von der Einrichtung abgestrahlten Schalls oder der mechanischen Schwingung der Einrichtung,
   - Bestimmen des Frequenzspektrums des Schwingungssignals,
   - Bestimmen des Schwingungswerts zumindest einer ungeraden Harmonischen im Frequenzspektrum,
   - Vergleichen des Schwingungswerts der ungeraden Harmonischen mit dem Schwingungswert zumindest einer geraden Harmonischen im Frequenzspektrum,
   - Feststellen eines Gleichstromanteils, wenn sich der Schwingungswert der ungeraden Harmonischen vom Schwingungswert der geraden Harmonischen um ein vorgegebenes Ausmaß unterscheidet, **dadurch gekennzeichnet, dass** die beiden größten Schwingungswerte der geraden Frequenzen zueinander ins Verhältnis gesetzt werden und bei einem Verhältnis größer einem vorgegebenen Verhältnis das Vorliegen eines Gleichstromanteils mit einem Unsicherheitsfaktor versehen wird.

2. Verfahren nach Anspruch 1, **dadurch gekennzeichnet, dass** für das Feststellen eines Gleichstromanteils eine Wahrscheinlichkeit für das Vorliegen eines Gleichstromanteils angegeben wird, wobei die Wahrscheinlichkeit umso größer ist, je größer der Unterschied zwischen dem Schwingungswert der mindestens einen ungeraden Harmonischen und dem Schwingungswert der mindestens einen geraden Harmonischen ist.

3. Verfahren nach Anspruch 2, **dadurch gekennzeichnet, dass** für verschiedene Wahrscheinlichkeiten für das Vorliegen eines Gleichstromanteils entsprechend verschiedene Unterschiede vorgegeben werden.

4. Verfahren nach einem der Ansprüche 1 bis 3, **dadurch gekennzeichnet, dass** der Schwingungswert einer oder mehrerer gerader Frequenzen mit einem Schwingungswert des Rauschens des Schwingungssignals verglichen wird und bei einem, gegenüber einer vorgegebenen Differenz zwischen den Schwingungswerten, geringeren Unterschied das Vorliegen eines Gleichstromanteils mit einem Unsicherheitsfaktor versehen wird.

5. Verfahren nach einem der Ansprüche 1 bis 4, **dadurch gekennzeichnet, dass** die beiden größten Schwingungswerte der ungeraden Frequenzen, die ungleich der Grundfrequenz sind, zueinander ins Verhältnis gesetzt werden und bei einem Verhältnis größer einem vorgegebenen Verhältnis das Vorliegen eines Gleichstromanteils mit einem Unsicherheitsfaktor versehen wird.

6. Verfahren nach einem der Ansprüche 1 bis 5, **dadurch gekennzeichnet, dass** der Schwingungswert der Grundschwingung mit dem Schwingungswert der restlichen gemessenen Frequenzen ins Verhältnis gesetzt wird und bei einem Verhältnis größer einem vorgegebenen Verhältnis das Vorliegen eines Gleichstromanteils mit einem Unsicherheitsfaktor versehen wird.

7. Verfahren nach einem der Ansprüche 1 bis 6, **dadurch gekennzeichnet, dass** das Vorliegen eines Gleichstromanteils mit einer niedrigeren Wahrscheinlichkeit bewertet wird, wenn sich der Schwingungswert der ungeraden Harmonischen vom Schwingungswert der geraden Harmonischen um ein vorgegebenes Ausmaß unterscheidet und dieser Unterschied mit zunehmendem Laststrom zunimmt.

8. Verfahren nach einem der Ansprüche 1 bis 7, **dadurch gekennzeichnet, dass** das Verfahren nach einem der Ansprüche 1 bis 7 mit einer unterschiedlichen Anzahl an geraden und/oder ungeraden Frequenzen wiederholt wird und eine Abweichung beim Feststellen eines Gleichstromanteils als Maß für die Robustheit des Ergebnisses herangezogen wird.

9. Computerprogrammprodukt, welches ein Programm umfasst, das direkt in einen Prozessor eines Computers ladbar ist, mit Programm-Mitteln, um alle Schritte des Verfahrens nach einem der Ansprüche 1 bis 8 auszuführen, wenn das Programm vom Prozessor ausgeführt wird.

**Claims**

1. Method for detecting a direct current component in an inductive device, for example in a transformer or an inductor, comprising the following method steps using a computer:

   - recording an oscillation signal, either of the sound emitted by the device or of the mechanical oscillation of the device,
   - determining the frequency spectrum of the oscillation signal,
   - determining the oscillation value of at least one odd harmonic in the frequency spectrum,
   - comparing the oscillation value of the odd harmonic with the oscillation value of at least one even harmonic in the frequency spectrum,
   - determining a direct current component if the oscillation value of the odd harmonic differs by a predefined extent from the oscillation value of the even harmonic, **characterized in that** the two largest oscillation values of the even frequencies are related to one another, and the presence of a direct current component is provided with an uncertainty factor in the event of a ratio greater than a predefined ratio.

2. Method according to Claim 1, **characterized in that** a probability of the presence of a direct current component is stated for the determination of a direct current component, wherein the probability is higher, the greater the difference between the oscillation value of the at least one odd harmonic and the oscillation value of the at least one even harmonic.

3. Method according to Claim 2, **characterized in that** different differences are accordingly predefined for different probabilities of the presence of a direct current component.

4. Method according to one of Claims 1 to 3, **characterized in that** the oscillation value of one or more even frequencies is compared with an oscillation value of the noise of the oscillation signal, and the presence of a direct current component is provided with an uncertainty factor in the case of a difference which is smaller than a predefined difference between the oscillation values.

5. Method according to one of Claims 1 to 4, **characterized in that** the two largest oscillation values of the odd frequencies, which are not equal to the fundamental frequency, are related to one another, and the presence of a direct current component is provided with an uncertainty factor in the event of a ratio greater than a predefined ratio.

6. Method according to one of Claims 1 to 5, **characterized in that** the oscillation value of the fundamental oscillation is related to the oscillation value of the remaining measured frequencies, and the presence of a direct current component is provided with an uncertainty factor in the event of a ratio greater than a predefined ratio.

7. Method according to one of Claims 1 to 6, **characterized in that** the presence of a direct current component is assessed with a lower probability if the oscillation value of the odd harmonic differs by a predefined extent from the oscillation value of the even harmonic and this difference increases with increasing load current.

8. Method according to one of Claims 1 to 7, **characterized in that** the method according to one of Claims 1 to 7 is repeated with a different number of even and/or odd frequencies, and a deviation when determining a direct current component is used as a measure of the robustness of the result.

9. Computer program product comprising a program which can be directly loaded into a processor of a computer, having program means for carrying out all steps of the method according to one of Claims 1 to 8 when the program is executed by the processor.

**Revendications**

1. Procédé de détection d'une composante de courant continu dans un dispositif inductif, par exemple dans un transformateur ou une bobine, comprenant les stades de procédé suivants en utilisant un ordinateur :

- enregistrement d'un signal de vibration, soit du son émis par le dispositif, soit de la vibration mécanique du dispositif,
- détermination du spectre de fréquence du signal de vibration,
- détermination de la valeur vibratoire au moins d'un harmonique impair du spectre de fréquence,
- comparaison de la valeur vibratoire de l'harmonique impaire à la valeur vibratoire d'au moins un harmonique paire du spectre de fréquence,
- constatation d'une composante de courant continu, si la valeur vibratoire de l'harmonique impaire se distingue de la valeur vibratoire de l'harmonique paire dans une mesure donnée à l'avance, **caractérisé en ce que** l'on met, dans un rapport l'une par rapport à l'autre, les deux valeurs vibratoires les plus grandes des fréquences paires et, si un rapport est plus grand qu'un rapport donné à l'avance, on munit la présence d'une composante de courant continu d'un facteur d'insécurité.

2. Procédé suivant la revendication 1, **caractérisé en ce que,** pour la constatation d'une composante de courant continu, on indique une probabilité de la présence d'une composante de courant continu, dans lequel la probabilité est d'autant plus grande qu'est plus grande la différence entre la valeur vibratoire du au moins un harmonique impaire et la valeur vibratoire du au moins un harmonique paire.

3. Procédé suivant la revendication 2, **caractérisé en ce que,** pour des probabilités différentes de la présence d'une composante de courant continu, on prescrit des différences diverses en correspondance.

4. Procédé suivant l'une des revendications 1 à 3, **caractérisé en ce que** l'on compare la valeur vibratoire d'une ou de plusieurs fréquences paires à une valeur vibratoire du bruit du signal de vibration et, s'il y a une différence plus petite qu'une différence donnée à l'avance entre les valeurs vibratoires, on munit la présence de la composante de courant d'un facteur d'insécurité.

5. Procédé suivant l'une des revendications 1 à 4, **caractérisé en ce que** l'on met en rapport l'une par rapport à l'autre les deux valeurs vibratoires les plus grandes des fréquences impaires, qui ne sont pas égales à la fréquence fondamentale, et, si un rapport est plus grand qu'un rapport donné à l'avance, on munit la présence d'une composante de courant continu d'un facteur d'insécurité.

6. Procédé suivant l'une des revendications 1 à 5, **caractérisé en ce que** l'on met en rapport la valeur vibratoire de la vibration fondamentale et la valeur vibratoire du reste des fréquences mesurées et, si un rapport est plus grand qu'un rapport donné à l'avance, on munit la présence d'une composante de courant continu d'un facteur d'insécurité.

7. Procédé suivant l'une des revendications 1 à 6, **caractérisé en ce que** l'on évalue la présence d'une composante de courant continu ayant une probabilité assez petite, si la valeur vibratoire des harmoniques impaire se distingue de la valeur vibratoire des harmoniques paires dans une mesure donnée à l'avance et si cette différence augmente au fur et à mesure qu'augmente le courant de charge.

8. Procédé suivant l'une des revendications 1 à 7, **caractérisé en ce que** l'on répète le procédé suivant l'une des revendications 1 à 7 avec un nombre différent de fréquences paires et/ou impaires, et on tire parti d'un écart, à la constatation d'une composante de courant continu, comme mesure de la robustesse du résultat.

9. Produit de programme d'ordinateur, qui comprend un programme, qui peut être chargé directement dans un processeur d'un ordinateur, comprenant des moyens de programme pour exécuter tous les stades du procédé suivant l'une des revendications 1 à 8, lorsque le programme est exécuté par le processeur.

**EP 3 736 580 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2905627 A1